# EUROPEAN PATENT APPLICATION

(11) **EP 4 357 419 A1**
(43) Date of publication of application: **24.04.2024**
(21) Application number: 22824709.4
(22) Date of filing: 11.05.2022
(51) Int. Cl.: C08L 83/07, C08K 3/08, C08L 83/05, H01L 23/373

(54) **THERMALLY-CONDUCTIVE POLYSILOXANE COMPOSITION**

(30) Priority: 16.06.2021 JP 2021100448
(71) Applicant: Momentive Performance Materials Japan LLC, Tokyo 107-6119 (JP)
(72) Inventor: IIDA, Isao, Tokyo 107-6119 (JP)
(74) Representative: Müller-Boré & Partner Patentanwälte PartG mbB
(86) International application number: PCT/JP2022/019901
(87) International publication number: WO 2022/264715

(57) **Abstract**

Provided are: a thermally-conductive polysiloxane composition having high thermal conductivity and exceptional workability due to low viscosity; and a heat-dissipating material that uses the thermally-conductive polysiloxane composition. The thermally-conductive polysiloxane composition contains (A) a silver powder, (B) a polyorganosiloxane containing one or more aliphatic unsaturated groups in a molecule, (C) a polyorganohydrogensiloxane having two or more hydrogen atoms bonded to a silicon atom in a molecule, and (D) a platinum-based catalyst, wherein the component (A) includes (A-1) a flaky silver powder having a tapped density of 3.0 to 10.0 g/cm³ and an average particle size of 1 to 20 µm, and (A-2) an agglomerated silver powder having a tapped density of 1.0 to 5.0 g/cm³ and an average particle size of 1 to 10 µm, and the content ratio of component (A-1) and component (A-2) in 100 mass% of the thermally-conductive polysiloxane composition is 70 to 98 mass%.

## Description

### TECHNICAL FIELD

The present invention relates to a thermally conductive polysiloxane composition.

### BACKGROUND ART

Electronic devices year after year have become higher in the integration and speed, and, according to such a tendency, demand for heat dissipation materials for dealing with heat generated from devices is increasing. In the heat dissipation materials, a silicone resin composition is widely used. A silicone resin cannot enhance the thermal conductivity by itself and therefore, a thermally conductive filler and the silicone resin are used in combination. It has been known that, as a thermally conductive filler, a material having a higher thermal conductivity than that of a silicone resin as a binder, such as a silica powder, alumina, boron nitride, aluminum nitride, or magnesium oxide, is added (Patent Literature 1).

Further, a thermally conductive silicone composition using a silver powder having a high thermal conductivity as a thermally conductive filler has been known. For example, there is disclosed a thermally conductive silicone composition comprising an organopolysiloxane having a specific structure and kinematic viscosity; and a silver powder having a tap density of 3.0 g/cm³ or more and a specific surface area of 2.0 m²/g or less, wherein the organopolysiloxane and the silver powder are contained in a predetermined ratio, and it is shown that the silver powder having an aspect ratio of 2.0 to 150.0 can be preferably used (Patent Literature 2). Furthermore, there is disclosed a thermally conductive silicone composition comprising an organopolysiloxane having a specific structure and kinematic viscosity; a silver powder having a tap density of 3.0 g/cm³ or more, a specific surface area of 2.0 m²/g or less, and an aspect ratio of 2.0 to 150.0; a thermally conductive filler other than the silver powder, which has an average particle diameter of 5 to 100 µm and a thermal conductivity of 10 W/m°C or more; and a specific catalyst, wherein the organopolysiloxane, the silver powder, the thermally conductive filler, and the catalyst are contained in a predetermined ratio (Patent Literature 3). It has been shown that the thermally conductive silicone compositions of Patent Literatures 2 and 3 exhibit excellent heat dissipation effect.

### CITATION LIST

### Patent Literature

Patent Literature 1: JP 2002-003831 A
Patent Literature 2: JP 2017-66406 A
Patent Literature 3: WO 2017/159252 A1

### SUMMARY OF INVENTION

### Technical Problem

However, the silicone composition of Patent Literature 1 had only unsatisfactory thermal conductivity. The silicone composition of Patent Literatures 2 and 3 exhibited certain thermal conductivity, but, when adding the silver powder to the silicone composition at a high filling rate, the composition was increased in viscosity, so that the working properties became poor. With respect to the silicone composition of Patent Literatures 2 and 3, when the silver powder was added to the silicone composition at a high filling rate in such an amount that the working properties were not lowered, the resultant composition had only unsatisfactory thermal conductivity.

Accordingly, the problem to be solved by the present invention is to provide a thermally conductive polysiloxane composition which is advantageous not only in that the composition has a low viscosity so that excellent working properties can be achieved, but also in that the composition has high thermal conductivity, and a heat dissipation material using the composition.

### Solution to Problem

The present inventors have conducted extensive and intensive studies on silver powders as a thermally conductive material. As a result, it has been found that the polysiloxane composition using two types of silver powders each having a specific form in combination is advantageous not only in that the composition has a low viscosity so that excellent working properties can be achieved, but also in that the composition has excellent thermal conductivity, and the present invention has been completed.

The gist of the present invention is as follows.
[1] A thermally conductive polysiloxane composition comprising (A) a silver powder, (B) a polyorganosiloxane having at least one aliphatic unsaturated group in the molecule thereof, (C) a polyorganohydrogensiloxane having in the molecule thereof two or more hydrogen atoms bonded to silicon atoms, and (D) a platinum catalyst, the component (A) comprising (A-1) a flake silver powder having a tap density of 3.0 to 10.0 g/cm³ and an average particle diameter of 1 to 20 µm, and (A-2) an aggregated silver powder having a tap density of 1.0 to 5.0 g/cm³ and an average particle diameter of 1 to 10 µm, the content of the component (A-1) and the component (A-2) in 100% by mass of the thermally conductive polysiloxane composition being 70 to 98% by mass.
[2] The thermally conductive polysiloxane composition according to item [1] above, wherein the mass ratio of component (A-1)/component (A-2) is 0.3 to 1.0.
[3] The thermally conductive polysiloxane composition according to item [1] or [2] above, further comprising (E) a compound having at least one dialkoxysilyl group or trialkoxysilyl group in the molecule thereof.
[4] The thermally conductive polysiloxane composition according to item [3] above, wherein the component (E) is a compound represented by the following general formula (1): 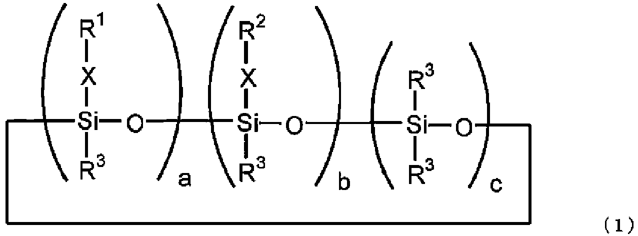 wherein the unit containing R¹, the unit containing R², and the unit represented by SiR³₂O are not necessarily arranged as shown in the general formula (1), and the order of arrangement is optional,
   R¹ is a group having an alkoxysilyl group having 1 to 4 carbon atoms,
   R² is a group having a siloxane unit represented by the following general formula (2): 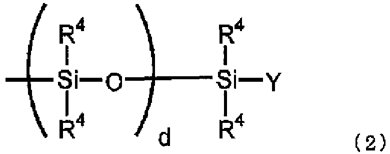 wherein each R⁴ is independently a monovalent hydrocarbon group having 1 to 12 carbon atoms, Y is a group selected from the group consisting of R¹, R⁴, and an aliphatic unsaturated group, and d is an integer of 2 to 500;
   or a monovalent hydrocarbon group having 6 to 18 carbon atoms, each X is independently a divalent hydrocarbon group having 2
   to 10 carbon atoms,
      each of a and b is independently an integer of 1 or more,
      c is an integer of 0 or more,
      wherein a + b + c is an integer of 4 or more, and each R³ is independently a monovalent hydrocarbon group
   having 1 to 6 carbon atoms or a hydrogen atom.
[5] A heat dissipation material comprising a cured product of the thermally conductive polysiloxane composition according to any one of items [1] to [4] above.

### Advantageous Effects of Invention

In the present invention, there can be provided a thermally conductive polysiloxane composition which is advantageous not only in that the composition has a low viscosity so that excellent working properties can be achieved, but also in that the composition has high thermal conductivity, and a heat dissipation material using the composition.

### DESCRIPTION OF EMBODIMENTS

The thermally conductive polysiloxane composition of the present invention comprises (A) a silver powder, (B) a polyorganosiloxane having at least one aliphatic unsaturated group in the molecule thereof, (C) a polyorganohydrogensiloxane having in the molecule thereof two or more hydrogen atoms bonded to silicon atoms, and (D) a platinum catalyst, wherein the component (A) comprises (A-1) a flake silver powder having a tap density of 3.0 to 10.0 g/cm³ and an average particle diameter of 1 to 20 µm, and (A-2) an aggregated silver powder having a tap density of 1.0 to 5.0 g/cm³ and an average particle diameter of 1 to 10 µm, wherein the content of the component (A-1) and the component (A-2) in 100% by mass of the thermally conductive polysiloxane composition is 70 to 98% by mass.

### [Component (A)]

Component (A) is a silver powder, which is a component to impart thermal conductivity to the polysiloxane composition. With respect to component (A), (A-1) a flake silver powder having a tap density of 3.0 to 10.0 g/cm³ and having an average particle diameter of 1 to 20 µm, and (A-2) an aggregated silver powder having a tap density of 1.0 to 5.0 g/cm³ and having an average particle diameter of 1 to 10 µm are used in combination, and therefore, even when component (A) is added to the polysiloxane composition at a high filling rate, the composition not only maintains a low viscosity but also can achieve high thermal conductivity.

### <Component (A-1)>

Component (A-1) is a flake silver powder having a tap density of 3.0 to 10.0 g/cm³ and an average particle diameter of 1 to 20 µm. The silver powder which is component (A-1) can advantageously improve the thermal conductivity. In the present invention, the flake silver powder indicates a silver powder having a substantially flat plane (X-Y plane) and having a thickness (Z) which is substantially uniform.

Component (A-1) has a tap density of 3.0 to 10.0 g/cm³. Component (A-1) has a tap density in the above-mentioned range, and therefore the filling rate of component (A-1) in the composition can be increased, making it possible to achieve both low viscosity and high thermal conductivity. The tap density of component (A-1) is preferably 3.5 to 8.0 g/cm³, more preferably 3.5 to 7.0 g/cm³, and further preferably 3.7 to 6.0 g/cm³.

In the present invention, the tap density is a value obtained by weighing 100 g of a silver powder, permitting the silver powder to slowly fall into a 100 ml measuring cylinder using a funnel, then placing the measuring cylinder on a tap density measuring apparatus, allowing the measuring cylinder to fall 600 times with a drop distance of 20 mm and at a speed of 60 times/minute, and determining a tap density from the volume of the compressed silver powder.

Component (A-1) has an average particle diameter of 1 to 20 µm. Component (A-1) has a peak of the particle size distribution in the range of from 1 to 20 µm. Component (A-1) has an average particle diameter of 1 to 20 µm, and therefore, even when component (A-1) is added to the polysiloxane composition at a high filling rate, component (A-1) is unlikely to suffer settling or the like, and the thermally conductive polysiloxane composition tends to be improved in stability, thereby making it possible to lower the viscosity of the composition and to improve thermal conductivity of a cured product of the composition. The average particle diameter of component (A-1) is more preferably 2 to 15 µm, and especially preferably 3 to 10 µm.

In the present invention, the measured value of average particle diameter of component (A-1) is a median diameter (d50) measured by a laser diffraction/scattering method. A median diameter (d50) by a laser diffraction/scattering method can be measured using, for example, SALD-2300, manufactured by Shimadzu Corporation.

From the viewpoint of reducing the viscosity of the polysiloxane composition when adding component (A-1) to the composition at a high filling rate, component (A-1) preferably has a specific surface area of 0.05 to 2.0 m³/g, more preferably 0.06 to 1.0 m³/g, and further preferably 0.08 to 0.5 m³/g, as measured by a BET method.

From the viewpoint of adding component (A-1) to the polysiloxane composition at a high filling rate, the aspect ratio of component (A-1) is preferably 2.0 to 150.0; more preferably in the range of from 3.0 to 100.0, and further preferably in the range of from 3.0 to 50.0.

In the present description, the aspect ratio is determined as follows. The flake silver powder is observed using a scanning electron microscope (SEM), and, when the maximum diameter of the powder particle on the above-mentioned X-Y plane is taken as a long diameter and the thickness (Z) of the particle is taken as a short diameter, the aspect ratio is determined as a long diameter/short diameter ratio. In the present description, the aspect ratio is an average of the long diameter/short diameter ratio values measured with respect to 100 flake silver powder particles.

With respect to the method for producing the silver powder, there is no particular limitation, but examples include an electrolytic method, a pulverization method, a heat treatment method, an atomization method, and a reducing method. The silver powder may have been subjected to hydrophobicity treatment by a known method. With respect to the silver powder which is component (A-1), the silver powder produced by the above-mentioned method may be used as such, or the silver powder which is pulverized so as to satisfy the above-mentioned numerical ranges may be used, as long as the silver powder has a flake form. In the case where the silver powder is pulverized, there is no particular limitation with respect to the apparatus for pulverization, and examples include known apparatuses, such as a stamp mill, a ball mill, an oscillating mill, a hammer mill, a rolling mill roll, and a mortar.

The silver powder which is component (A-1) is commercially available, and, for example, SILCOAT (registered trademark) AgC-2190H and AgC-221A, manufactured by Fukuda Metal Foil & Powder Co., Ltd., Silbest (registered trademark) TC-466, manufactured by Tokuriki Honten Co., Ltd., or FA-D-3, manufactured by DOWA Electronics Materials Co., Ltd. can be used.

One type of component (A-1) may be individually used, or two or more types of components (A-1) may be used in combination.

### <Component (A-2)>

Component (A-2) is an aggregated silver powder having a tap density of 1.0 to 5.0 g/cm³ and an average particle diameter of 1 to 10 µm. In the present invention, the aggregated silver powder indicates silver particles formed from two or more primary particles which have a primary particle diameter of 0.1 to 5.0 µm, and which have suffered aggregation. The primary particle diameter of the particles is preferably in the range of from 0.2 to 2.0 µm, and more preferably in the range of from 0.5 to 1.0 µm. The number of the primary particles in the aggregated silver powder is preferably 5 or more, and more preferably 10 or more. With respect to the upper limit of the number of the primary particles, there is no particular limitation, but the upper limit is, for example, 1,000 or less.

The aggregated silver powder may contain primary particles with a primary particle diameter that falls outside of the range of from 0.1 to 5.0 µm, and which have suffered aggregation. The proportion of the number of the primary particles having a primary particle diameter of 0.1 to 5.0 µm relative to the number of all the primary particles constituting the aggregated silver powder is preferably 50% or more, more preferably 70% or more, and further preferably 80% or more. The upper limit of the proportion of the number of the primary particles having a primary particle diameter of 0.1 to 5.0 µm relative to the number of all the primary particles constituting the aggregated silver powder is 100%.

In the present invention, a particle diameter of the primary particles forming the aggregated silver powder can be determined by observing the aggregated silver powder using a scanning electron microscope (SEM) and obtaining equivalent circle diameters of the observed primary particles.

With respect to the polysiloxane composition having only component (A-1) added at a high filling rate in such an amount that the working properties were not lowered, a cured product of the composition had unsatisfactory thermal conductivity. The present inventors have studies with a view toward improving the filling efficiency of the silver powder. As a result, it has been found that the composition using component (A-1) and component (A-2) in combination is advantageous not only in that a uniform composition can be obtained without increasing the viscosity of the composition, but also in that the composition can achieve high thermal conductivity, as compared to the composition using component (A-1) solely. It is considered that, in the case where the flake silver powder and the aggregated silver powder are in contact with each other, the contact area between the silver particles is increased, as compared to that in the case where the particles of the flake silver powder are in contact with each other, or the flake silver powder and a single particulate silver powder are in contact with each other, and therefore high thermal conductivity can be obtained.

Component (A-2) has a tap density of 1.0 to 5.0 g/cm³. Component (A-2) has a tap density in the above-mentioned range, and therefore the composition using component (A-1) and component (A-2) in combination can be reduced in viscosity, and further a cured product of the composition can be improved in thermal conductivity. The tap density of component (A-2) is preferably 1.3 to 4.0 g/cm³, and more preferably 1.5 to 3.0 g/cm³. The method for measuring a tap density is the same as that for component (A-1).

Component (A-2) has an average particle diameter of 1 to 10 µm. Component (A-2) has a peak of the particle size distribution in the range of from 1 to 10 µm. Component (A-2) has an average particle diameter of 1 to 10 µm, and therefore the composition using component (A-1) and component (A-2) in combination can be reduced in viscosity, and further a cured product of the composition can be improved in thermal conductivity. The average particle diameter of component (A-2) is more preferably 1 to 8 µm, further preferably 1 to 6 µm, and especially preferably 2 to 6 µm.

In the present invention, the measured value of average particle diameter of component (A-2) is a median diameter (d50) measured by an air permeability method. A median diameter (d50) by an air permeability method can be measured using, for example, Subsieve AutoSizer, manufactured by Micromeritics Instruments Corporation.

From the viewpoint of adding component (A-2) to the polysiloxane composition at a high filling rate, component (A-2) preferably has a specific surface area of 0.05 to 2.0 m³/g, more preferably 0.06 to 1.0 m³/g, and further preferably 0.08 to 0.8 m³/g, as measured by a BET method.

With respect to the method for producing the silver powder which is component (A-2), there is no particular limitation, but examples include an electrolytic method, a pulverization method, a heat treatment method, an atomization method, and a reducing method. The silver powder may have been subjected to hydrophobicity treatment by a known method.

The silver powder which is component (A-2) is commercially available, and, for example, SILCOAT (registered trademark) AgC-74SE, AgC-131, and AgC-101H, manufactured by Fukuda Metal Foil & Powder Co., Ltd. can be used.

One type of component (A-2) may be individually used, or two or more types of components (A-2) may be used in combination.

### <Content of component (A-1) and component (A-2)>

The content of component (A-1) and component (A-2) in 100% by mass of the thermally conductive polysiloxane composition is 70 to 98% by mass. The content of component (A-1) and component (A-2) in the composition is in the above-mentioned range, and therefore the thermally conductive polysiloxane composition having excellent thermal conductivity can be obtained. The content of component (A-1) and component (A-2) in 100% by mass of the thermally conductive polysiloxane composition is preferably 80 to 98% by mass, and more preferably 85 to 97% by mass.

Component (A) may contain a silver powder other than component (A-1) and component (A-2) in such an amount that the effects aimed at by the present invention are not sacrificed. The content of the total of component (A-1) and component (A-2) in 100% by mass of component (A) is preferably 80% by mass or more, more preferably 85% by mass or more, and further preferably 90% by mass or more. The upper limit of the content of the total of component (A-1) and component (A-2) in 100% by mass of component (A) is 100% by mass.

It is preferred that the mass ratio of component (A-1)/component (A-2) is 0.3 to 1.0. When the mass ratio of component (A-1)/component (A-2) is smaller than 0.3, it is likely that the composition having the silver powder added at a high filling rate is increased in viscosity, so that the working properties become poor, and, when the mass ratio of component (A-1)/component (A-2) is larger than 1.0, the cured product of the composition is likely to have poor thermal conductivity. The mass ratio of component (A-1)/component (A-2) is more preferably 0.4 to 0.9, and further preferably 0.5 to 0.8.

### [Component (B)]

Polyorganosiloxane (B) having at least one aliphatic unsaturated group in the molecule thereof is a component which serves as a base polymer in the composition. With respect to component (B), there is no particular limitation as long as it has at least one aliphatic unsaturated group bonded to a silicon atom per molecule and can undergo an addition reaction with a hydrosilyl group (Si-H group) of component (C). With respect to the polyorganosiloxane having at least one aliphatic unsaturated group in the molecule thereof, which is component (B), a compound represented by the following average compositional formula (I) can be used:

R⁴¹ⱼR⁴²ₖSiO_{[4-(j+k)]/2} (I)

wherein R⁴¹ is an aliphatic unsaturated group, R⁴² is a substituted or unsubstituted monovalent hydrocarbon group containing no aliphatic unsaturated bond, and j and k are a positive number that satisfies the relationships: 0 < j < 3, 0 < k < 3, and 1 <j + k < 3.

The aliphatic unsaturated group in R⁴¹ preferably has 2 to 8 carbon atoms, and examples of such groups include a vinyl group, an allyl group, a propenyl group, a 1-butenyl group, and a 1-hexenyl group, and preferred is a vinyl group. One or more, preferably two or more aliphatic unsaturated groups are contained per molecule. Further, the aliphatic unsaturated groups may be bonded to a silicon atom at an end of the molecular chain, bonded to a silicon atom in the middle of the molecular chain, or bonded to both of them.

Specific examples of R⁴² include alkyl groups, such as a methyl group, an ethyl group, a propyl group, an isopropyl group, a butyl group, an isobutyl group, and a tert-butyl group; cycloalkyl groups, such as a cyclopentyl group, a cyclohexyl group, and a cyclobutyl group; aryl groups, such as a phenyl group, a tolyl group, a xylyl group, and a naphthyl group; aralkyl groups, such as a benzyl group, a 2-phenylethyl group, a 2-methyl-2-phenylethyl group, and a phenylpropyl group; groups obtained by replacing part or all of hydrogen atoms of the above hydrocarbon group by a halogen atom, such as chlorine, fluorine, or bromine, or a cyano group, for example, halogenated hydrocarbon groups, such as a chloromethyl group, a trifluoropropyl group, a 3,3,3-trifluoropropyl group, a 2-(nonafluorobutyl)ethyl group, a 2-(heptadecafluorooctyl)ethyl group, a chlorophenyl group, a bromophenyl group, a dibromophenyl group, a tetrachlorophenyl group, a fluorophenyl group, and a difluorophenyl group, and cyanoalkyl groups, such as an α-cyanoethyl group, a β-cyanopropyl group, and a γ-cyanopropyl group. Of these, R⁴² is preferably an alkyl group or an aryl group, and more preferably a methyl group or a phenyl group.

j and k are preferably a number that satisfies the relationships: 0.0005 ≤ j ≤ 1, 1.5 ≤ k < 2.4, and 1.5 < j + k < 2.5, and more preferably a number that satisfies the relationships: 0.001 ≤ j ≤ 0.5, 1.8 ≤ k ≤ 2.1, and 1.8 < j + k ≤ 2.2.

The molecular structure of component (B) can be linear, branched, or cyclic, but is preferably linear or branched. Particularly, component (B) is especially preferably a linear polyorganosiloxane having both ends capped by an M^{vi} unit (dimethylvinylsiloxane unit), and having an intermediate unit comprised only of a D unit (dimethylsiloxane unit).

Component (B) preferably has a viscosity at 23°C of 10 to 100,000 mPa•s, and more preferably 20 to 10,000 mPa•s.

The amount of component (B) contained, relative to 100 parts by mass of component (A), is preferably 1.5 to 35 parts by mass, more preferably 1.5 to 30 parts by mass, further preferably 1.5 to 28 parts by mass, and especially preferably 1.5 to 15 parts by mass.

One type of component (B) may be individually used, or two or more types of components (B) may be used in combination.

### [Component (C)]

Polyorganohydrogensiloxane (C) having two or more hydrogen atoms bonded to silicon atoms in the molecule thereof is a component which serves as a crosslinking agent for component (B). Component (C) has per molecule two or more, preferably three or more hydrogen atoms bonded to silicon atoms. The hydrogen atoms may be bonded to a silicon atom at an end of the molecular chain, bonded to a silicon atom in the middle of the molecular chain, or bonded to both of them. Alternatively, a polyorganohydrogensiloxane having hydrogen atoms bonded only to silicon atoms at both ends can be used. The molecular structure of component (C) may be any of linear, branched, cyclic, and three-dimensional network structures. One type of component (C) may be individually used, or two or more types of components (C) may be used in combination.

As component (C), a compound represented by the following average compositional formula (II) can be used:

R⁵¹ₘHₙSiO_{[4-(m+n)]/2} (II)

wherein R⁵¹ is a substituted or unsubstituted monovalent hydrocarbon group containing no aliphatic unsaturated bond, and m and n are a number that satisfies the relationships: 0.5 ≤ m ≤ 2, 0 < n ≤ 2, and 0.5 < m + n ≤ 3.

As specific examples of R⁵¹, there can be mentioned groups mentioned above as examples of R⁴² for the average compositional formula (I). Of these, in view of the easiness of synthesis and the cost, an alkyl group is preferred, and a methyl group is more preferred.

m and n are preferably a number that satisfies the relationships: 0.6 ≤ m ≤ 1.9, 0.01 ≤ n ≤ 1.0, and 0.6 ≤ m + n ≤ 2.8.

Component (C) preferably has a viscosity of 10 to 500 mPa•s at 23°C.

Component (C) is especially preferably a linear polymethylhydrogensiloxane having both ends capped by an M unit (trimethylsiloxane unit), and having an intermediate unit comprised only of a D^{H} unit (methylhydrogensiloxane unit); a linear polymethylhydrogensiloxane having both ends capped by an M unit (trimethylsiloxane unit), and having an intermediate unit comprised only of a D unit (dimethylsiloxane unit) and a D^{H} unit (methylhydrogensiloxane unit), wherein the amount of the methylhydrogensiloxane units is 0.1 to 2.0 mol, relative to 1 mol of the dimethylsiloxane units; or a polymethylhydrogensiloxane comprised only of an M^{H} unit (dimethylhydrogensiloxane unit) and a Q unit (SiO_{4/2} unit).

Component (C) is incorporated in such an amount that, relative to one aliphatic unsaturated group bonded to a silicon atom of component (B), the number of hydrogen atoms bonded to silicon atoms in component (C) is preferably 0.1 to 20, and more preferably 0.2 to 15. When the amount of component (C) incorporated is in the above range, the thermally conductive polysiloxane composition has excellent stability with time, and it is likely that when the composition is cured, the degree of crosslinking is satisfactory, so that a cured product having an appropriate hardness can be obtained.

### [Component (D)]

Platinum catalyst (D) is a component which accelerates curing after mixing together component (B) and component (C). As component (D), a well-known catalyst for use in a hydrosilylation reaction can be used. Examples of such catalysts include platinum black, platinum(IV) chloride, chloroplatinic acid, a reaction product of chloroplatinic acid and a monohydric alcohol, a complex of chloroplatinic acid and an olefin or a vinylsiloxane, a platinum-vinyltetramer complex, and platinum bisacetoacetate. The amount of component (D) incorporated can be appropriately selected according to, for example, a desired curing rate, and is preferably in the range of from 0.1 to 1,000 ppm, in terms of a platinum element, based on the total amount of component (B) and component (C). One type of component (D) may be individually used, or two or more types of components (D) may be used in combination.

Further, for obtaining a longer pot life, the activity of the catalyst can be suppressed by adding (D-2) a reaction inhibitor. Examples of known reaction inhibitors for metals of the platinum group include acetylenic alcohols, such as 2-methyl-3-butyn-2-ol and 1-ethynyl-2-cyclohexanol, and diallyl maleate.

### [Component (E)]

From the viewpoint of further reducing the viscosity of the thermally conductive polysiloxane composition to improve the working properties, the thermally conductive polysiloxane composition preferably contains (E) a compound having at least one dialkoxysilyl group or trialkoxysilyl group in the molecule thereof. Component (E) is preferably a compound having per molecule at least an alkoxysilyl group represented by the following general formula:

-SiR¹¹_{3-z}(OR¹²)_{z} (III)

wherein R¹¹ is an alkyl group having 1 to 6 carbon atoms, preferably a methyl group, R¹² is an alkyl group having 1 to 6 carbon atoms,
preferably a methyl group, and z is 2 or 3,
and especially preferably a compound represented by the general formula (1) below.

In the compound represented by the general formula (1), the unit containing R¹, the unit containing R², and the unit represented by SiR³₂O are not necessarily arranged as shown in the general formula (1), and it is understood that, for example, the unit represented by SiR³₂O may be present between the unit containing R¹ and the unit containing R². 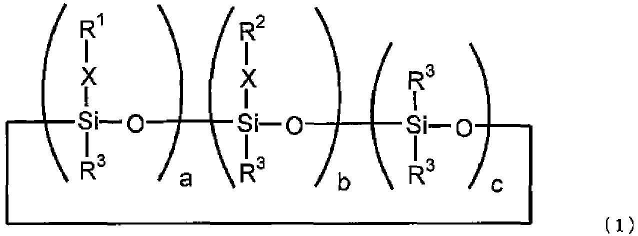
Wherein R¹ is a group having an alkoxysilyl group having 1 to 4 carbon atoms,
   R² is a group having a siloxane unit represented by the following general formula (2): 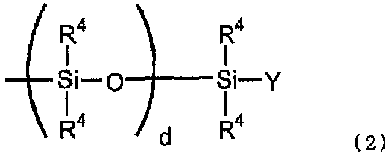 wherein each R⁴ is independently a monovalent hydrocarbon group having 1 to 12 carbon atoms, Y is a group selected from the group consisting of R¹, R⁴, and an aliphatic unsaturated group, and d is an integer of 2 to 500, preferably an integer of 4 to 400, more preferably an integer of 10 to 200, and especially preferably an integer of 10 to 60;
or a monovalent hydrocarbon group having 6 to 18 carbon atoms,
   each X is independently a divalent hydrocarbon group having 2 to 10 carbon atoms,
   each of a and b is independently an integer of 1 or more,
   c is an integer of 0 or more,
   wherein a + b + c is an integer of 4 or more, and each R³ is independently a monovalent hydrocarbon group
having 1 to 6 carbon atoms or a hydrogen atom.

With respect to the compounds represented by the general formula (1), compounds represented by the following structural formulae can be preferably used, but the compounds of the formula (1) are not limited to these compounds.

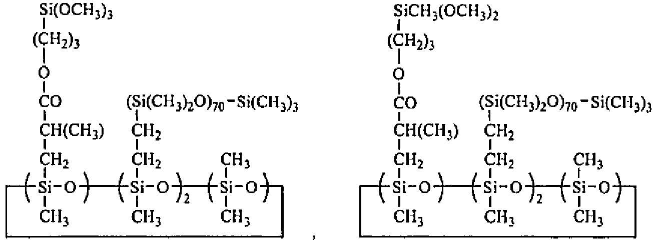

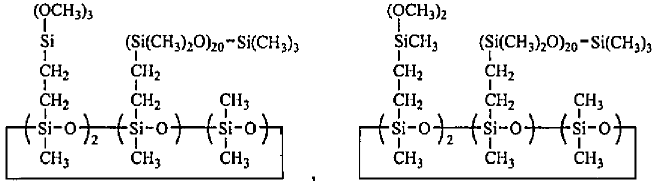

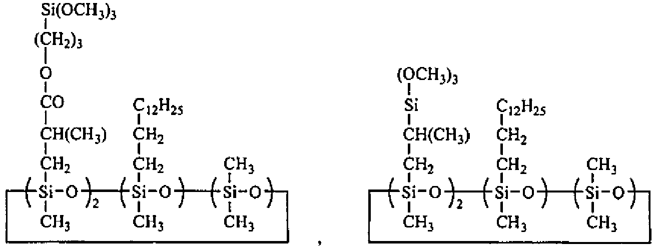

Further, as preferred examples of the compounds represented by the general formula (1), there can be mentioned compounds represented by the following structural formulae.

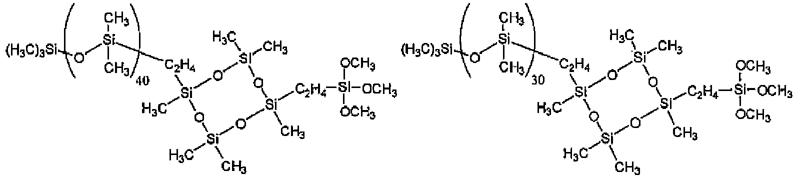

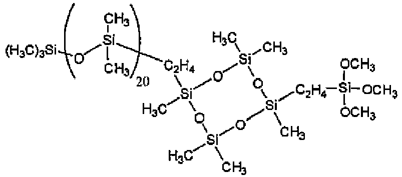

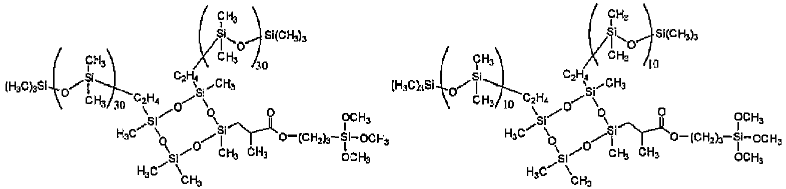

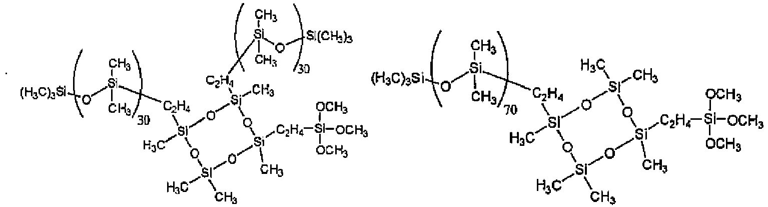

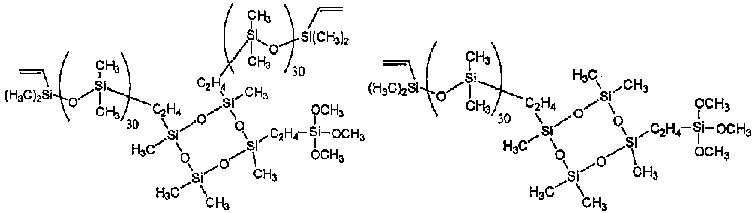

The amount of component (E) contained in the thermally conductive polysiloxane composition is preferably 0.1 to 20 parts by mass, more preferably 0.5 to 10 parts by mass, and especially preferably 0.5 to 5 parts by mass, relative to 100 parts by mass of component (A).

One type of component (E) may be individually used, or two or more types of components (E) may be used in combination.

### [Other components]

The thermally conductive polysiloxane composition can further contain, if necessary, a flame retardancy imparting agent, a heat resistance improving agent, a plasticizer, a colorant, a tackifier, a diluent, an organic or inorganic pigment having no thermal conductivity, a thermally conductive filler other than component (A); a polyorganosiloxane other than components (B), (C), and (E); a catalyst other than component (D), or the like in such an amount that the effects aimed at by the present invention are not sacrificed.

With respect to the thermally conductive filler other than component (A), there can be used, for example, a metal oxide, such as alumina, zinc oxide, magnesium oxide, or silica; a nitride, such as aluminum nitride or boron nitride; a metal, such as aluminum, copper, or gold; or core/shell particles of a metal/metal oxide.

### [Method for producing the thermally conductive polysiloxane composition]

The thermally conductive polysiloxane composition can be obtained by mixing components (A) to (D) and further optionally component (E) and other components by means of a mixer, such as a planetary mixer. During the mixing, if necessary, the mixture being mixed may be heated at a temperature in the range of from 50 to 150°C. For achieving further uniform finishing, it is preferred that the mixture is subjected to kneading operation under a high shear force. Examples of kneading apparatuses include a three-roll mill, a colloid mill, and a sand grinder, and, of these, preferred is a method using a three-roll mill.

### [Method for curing the thermally conductive polysiloxane composition]

As a method for curing the thermally conductive polysiloxane composition, for example, there can be mentioned a method in which the composition is applied to an adherend which needs heat dissipation, and then the composition is allowed to stand at room temperature, and a method in which the above applied composition is heated at a temperature of 50 to 200°C. From the viewpoint of quickly curing the composition, a method in which the applied composition is heated is preferably employed.

### [Heat dissipation material]

A heat dissipation material comprising a cured product of the thermally conductive polysiloxane composition has a thermal conductivity of 2.0 W/(m•K) or more, as measured at 23°C by a hot wire method. The thermal conductivity of the heat dissipation material is preferably 8 W/(m•K) or more, and more preferably 10 W/(m•K) or more. For controlling the thermal conductivity to enhance the heat dissipation effect, the content of component (A) in the composition is preferably 70% by mass or more, more preferably 80% by mass or more, and further preferably 85% by mass or more, and the content of component (A) can be increased according to the required thermal conductivity.

The heat dissipation material can be used as a heat dissipation material for a PC/server having mounted a CPU which generates a large amount of heat, and for electronic devices having mounted a power module, a VLSI (very large scale integrated circuit), or an optical part (such as an optical pickup or an LED); household appliances (e.g., AV devices, such as a DVD/HDD recorder (or player), a BD•DVD/HDD recorder (or player), and an FPD); PC peripheral devices; home video game consoles; automobiles; and industrial devices, such as an inverter and a switching power source.

### Examples

### <Components used>

### Component (A)

### Component (A-1): Flake silver powder

SILCOAT (registered trademark) AgC-2190H, manufactured by Fukuda Metal Foil & Powder Co., Ltd. (tap density: 4.35 g/cm³; apparent density: 2.64 g/cm³; median diameter (d50) measured by a laser diffraction/scattering method: 6.8 µm; BET specific surface area: 0.36 m²/g; aspect ratio: 12)

### Component (A-2): Aggregated silver powder

SILCOAT (registered trademark) AgC-74SE, manufactured by Fukuda Metal Foil & Powder Co., Ltd. (tap density: 1.89 g/cm³; apparent density: 1.02 g/cm³; median diameter (d50) measured by an air permeability method: 4.6 µm; BET specific surface area: 0.19 m²/g)

### Component (A'): Single particulate silver powder

SILCOAT (registered trademark) AgC-161, manufactured by Fukuda Metal Foil & Powder Co., Ltd. (tap density: 3.33 g/cm³; apparent density: 1.64 g/cm³; median diameter (d50) measured by a laser diffraction/scattering method: 4,6 µm; BET specific surface area: 0.79 m²/g)

### Component (B)

Dimethylpolysiloxane having both-ends capped by a vinyl group (viscosity: 3 Pa•s; vinyl group concentration: 0.08 mmol/g)

### Component (C)

Polymethylhydrogensiloxane: MD₂₀D^{H}₂₀M (viscosity: 0.03 Pa•s; H concentration: 7.3 mmol/g)

### Component (D)

Platinum catalyst: platinum content: 1.8% by mass; platinum-vinylsiloxane complex

### Component (D-2)

Reaction inhibitor: Diallyl maleate

### Component (E)

Trialkoxysilyl group-containing polyorganosiloxane:

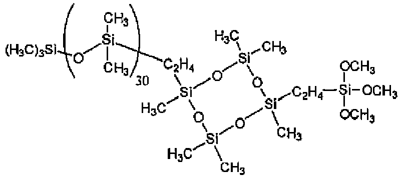

### <Measurement method>

### [Viscosity]

A viscosity of the composition at 23°C was measured in accordance with JIS K6249 using a rotational viscometer rotor No. 7 under conditions such that the number of revolutions was 20 rpm and the time was one minute.

### [Thermal conductivity]

A thermal conductivity was measured at 23°C in accordance with a Hot disk method using Hot Disk Thermal Constants Analyser (TPS 1500, manufactured by Kyoto Electronics Manufacturing Co., Ltd.).

### Examples 1 and 2 and Comparative Examples 1 to 3

Components (A), (B), and (E) shown in Table 1 were individually placed into a plastic vessel, and mixed by stirring using a planetary centrifugal mixer at room temperature for 5 minutes to obtain a mixture. Then, to the mixture were individually added components (C), (D), and (D-2), followed by mixing, obtaining thermally conductive polysiloxane compositions in Examples 1 and 2 and Comparative Examples 1 to 3. With respect to the thus obtained compositions, a viscosity was measured. The results are shown in Table 1.

With respect to each of the thermally conductive polysiloxane compositions in Examples 1 and 2 and Comparative Examples 1 to 3, the composition was cured by heating in a mold at 150°C for 1 hour to obtain a cured product of the thermally conductive polysiloxane composition having a thickness of 6 mm. With respect to the thus obtained cured product, a thermal conductivity was measured. The results are shown in Table 1.

**[Table 1]**

| Raw materials | | Example 1 | Example 2 | Comparative Example 1 | Comparative Example 2 | Comparative Example 3 |
|---|---|---|---|---|---|---|
| (A-1) | Flake silver powder | 35.00 | 30.00 | 86.00 | - | 35.00 |
| (A-2) | Aggregated silver powder | 51.00 | 56.00 | - | 86.00 | - |
| (A') | Single particulate silver powder | - | - | - | - | 51.00 |
| (B) | Dimethylpolysiloxene having both-ends capped by a vinyl group | 11.65 | 11.65 | 11.65 | 11.65 | 11.65 |
| (C) | Polymethγlhydrogenslloxane: MD₂₀D^{H}₂₀M | 1.20 | 1.20 | 1.20 | 1.20 | 1.20 |
| (D) | Plabnum-vinylsiloxane complex (Pt: 1.8% by mass) | 0.05 | 0.05 | 0.05 | 0.05 | 0.05 |
| (D-2) | Diallyl maleate | 0.10 | 0.10 | 0.10 | 0.10 | 0.10 |
| (E) | Trialkoxysilyl group-containing polyorganosiloxane | 1.00 | 1.00 | 1.00 | 1.00 | 1.00 |
| Viscosity: Pas | | 60 | 56 | 58 | Cannot be prepared | 70 |
| Thermal conductivity (Hot disk): W/mK | | 12.7 | 11.0 | 7.1 | | 1.8 |

With respect to the thermally conductive polysiloxane compositions in the Examples, in which component (A) comprises (A-1) a flake silver powder having a tap density of 3.0 to 10.0 g/cm³ and having an average particle diameter of 1 to 20 µm, and (A-2) an aggregated silver powder having a tap density of 1.0 to 5.0 g/cm³ and having an average particle diameter of 1 to 10 µm, wherein the content of component (A-1) and component (A-2) in 100% by mass of the thermally conductive polysiloxane composition is 70 to 98% by mass, the composition has a low viscosity, and therefore has excellent working properties, and the cured product of the composition has a high thermal conductivity.

In contrast, with respect to the composition in Comparative Example 1 in which only (A-1) a flake silver powder was used as component (A), the cured product of the composition had poor thermal conductivity. In Comparative Example 2 in which only (A-2) an aggregated silver powder was used as component (A), when mixing component (A-2) with components (B) and (E), the components were separated from one another, making it impossible to obtain a uniform mixture. With respect to the composition in Comparative Example 3 in which component (A-1) and (A') a single particulate silver powder were used in combination, the cured product of the composition had a considerably reduced thermal conductivity.

### Industrial Applicability

The thermally conductive polysiloxane composition of the present invention can be used as a heat dissipation material for various types of devices having a heat generating part, e.g., electronic devices, such as a personal computer.

## Claims

1. A thermally conductive polysiloxane composition comprising (A) a silver powder, (B) a polyorganosiloxane having at least one aliphatic unsaturated group in the molecule thereof, (C) a polyorganohydrogensiloxane having in the molecule thereof two or more hydrogen atoms bonded to silicon atoms, and (D) a platinum catalyst,
the component (A) comprising (A-1) a flake silver powder having a tap density of 3.0 to 10.0 g/cm³ and an average particle diameter of 1 to 20 µm, and (A-2) an aggregated silver powder having a tap density of 1.0 to 5.0 g/cm³ and an average particle diameter of 1 to 10 µm,
the content of the component (A-1) and the component (A-2) in 100% by mass of the thermally conductive polysiloxane composition being 70 to 98% by mass.

2. The thermally conductive polysiloxane composition according to claim 1, wherein the mass ratio of component (A-1)/component (A-2) is 0.3 to 1.0.

3. The thermally conductive polysiloxane composition according to claim 1 or 2, further comprising (E) a compound having at least one dialkoxysilyl group or trialkoxysilyl group in the molecule thereof.

4. The thermally conductive polysiloxane composition according to claim 3, wherein the component (E) is a compound represented by the following general formula (1): 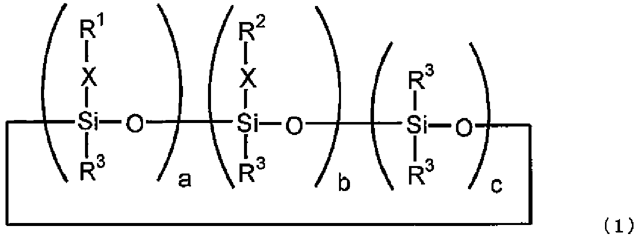
wherein the unit containing R¹, the unit containing R², and the unit represented by SiR³₂O are not necessarily arranged as shown in the general formula (1), and the order of arrangement is optional,
R¹ is a group having an alkoxysilyl group having 1 to 4 carbon atoms,
R² is a group having a siloxane unit represented by the following general formula (2): 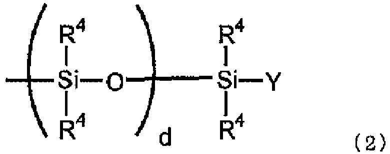 wherein each R⁴ is independently a monovalent hydrocarbon group having 1 to 12 carbon atoms, Y is a group selected from the group consisting of R¹, R⁴, and an aliphatic unsaturated group, and d is an integer of 2 to 500;
or a monovalent hydrocarbon group having 6 to 18 carbon atoms,
each X is independently a divalent hydrocarbon group having 2 to 10 carbon atoms,
each of a and b is independently an integer of 1 or more,
c is an integer of 0 or more,
wherein a + b + c is an integer of 4 or more, and
each R³ is independently a monovalent hydrocarbon group
having 1 to 6 carbon atoms or a hydrogen atom.

5. A heat dissipation material comprising a cured product of the thermally conductive polysiloxane composition according to claim 1 or 2.
